# EUROPEAN PATENT SPECIFICATION

(11) **EP 0 640 843 B1**
(45) Date of publication and mention of the grant of the patent: **23.05.2001**
(21) Application number: 94113617.8
(22) Date of filing: 31.08.1994
(51) Int. Cl.: G01R 33/561

(54) **Method and apparatus for magnetic resonance imaging**
Verfahren und Gerät zur Bilderzeugung mit magnetischer Resonanz
Méthode et appareil d'imagerie par résonance magnétique

(30) Priority: 31.08.1993 JP 21668293
(43) Date of publication of application: 01.03.1995
(73) Proprietor: KABUSHIKI KAISHA TOSHIBA, Kawasaki-shi, Kanagawa-ken 210-8572 (JP)
(72) Inventor: Kanazawa, Hitoshi, 93-25-A1-101, Nasu-gun, Tochigi-Ken (JP)
(74) Representative: Blumbach, Kramer & Partner GbR

(56) References cited:
- EP-A- 0 529 527
- EP-A- 0 572 074
- WO-A-93/01509
- MEDICAL PHYSICS, vol.18, September 1991, NEW YORK, USA pages 1032 - 1037 R.V. MULKERN ET AL.: 'Phase-encode order and its effect on contrast and artifact in single-shot RARE sequences'

## Description

The present invention relates to a method according to the preamble of claim 1 and apparatus for magnetic resonance imaging (MRI) using a nuclear magnetic resonance phenomenon, and more particularly to an imaging method and apparatus employing a multi-echo scanning method capable of performing a high speed scanning operation.

A variety of sequences for acquiring image data in magnetic resonance imaging have been employed at present. As one of the foregoing methods, a spin echo method (an SE method) is available which uses 90°-pulses (excitation pulses) and 180°-pulses (refocusing pulses).

As one of spin echo methods, a single echo scanning method has been known. The single echo scanning method has an arrangement that one 90°-pulses is supplied, and then one 180° -pulse is supplied after time TE/2 (TE: a predetermined echo time) has passed so as to acquire one spin echo signal generated in response to the supplied 180°-pulse. The foregoing collection process is repeated by the times corresponding to the required number of matrices. The echo time TE is set to be, for example, TE = 80 msec to 120 msec in a case where the static magnetic field is 0.5 T.

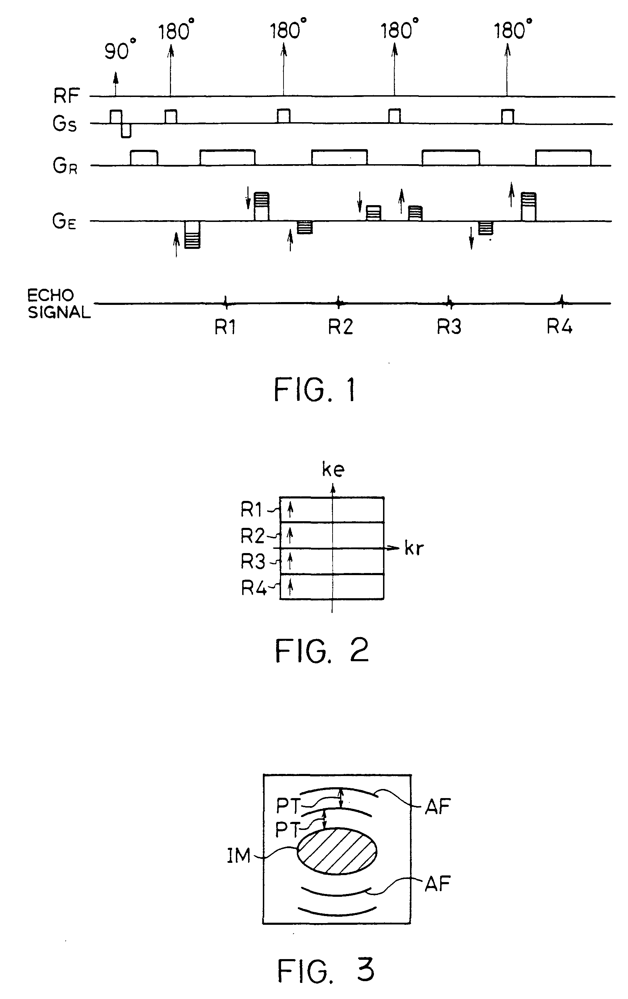

Also a multi-echo scanning method (hereinafter called a "fast SE method") for shortening the scan time has been known as one of the variety of spin echo methods. The fast SE method uses CPMG pulse trains or CP pulse trains and, as shown in Fig. 1, supplies one 90°- pulse and a plurality of 180°- pulses. As a result, one radio frequency excitation operation in accordance with one 90°- pulse generates a plurality of echo signals R1 to R4 (in a case where a 4 -echo method is employed). The echo signals R1 to R4 are respectively subjected to phase encoding using gradient field G_{E} having different intensities. The foregoing sequence is repeated several times so that echo data required to reconstruct one image is collected by the number of excitation operations that is smaller than the number required for the usual SE method. As a result, an advantage can be realized in that the time required to complete the scan can significantly be shortened.

The fast SE method is characterized in that a series of echo data items obtained from one radio frequency excitation operation using one 90°- pulse are, as shown in Fig. 2, arranged in direction Ke (in a direction of the spatial frequency of phase encoding) at the same intervals in the k space (the Fourier space).

However, the foregoing fast SE method raises a problem of ghost generation caused from the movement of a subject to be inspected during the scan (that is, the movement of the body) and/or pulsation of CSF (cereborospinal fluid) because a series of echo data items obtained from one radio frequency excitation operation using one 90°- pulse are arranged in the direction ke in the k space at the same intervals.

The foregoing fact will now be described in detail. The overall sequence performed by the fast SE method is usually completed in the order of 2 seconds to 3 seconds and one radio frequency excitation operation using one 90°-RF pulse is completed in the order of, for example, 100 msec. As contrasted with this, the subject to be inspected usually moves in the order of several seconds during the scan operation. As a result, if the subject to be inspected moves, the overall sequence is affected by the body movement such that the sequence is equally affected whenever the radio frequency excitation operation using one 90°- pulse is performed. If the subject to be inspected moves and the intensity of the signal from the subject to be inspected corresponding to each pixel of the image is changed whenever the radio frequency excitation operation using one 90°- pulse is performed, the echo data items are arranged in direction ke in the k space in the form that the amplitude of the echo data items is modulated with a period relating to the number of echoes (that is, in proportion to the number of echoes). As a result, there arises a problem in that ghost-like artifacts AF are generated on the reconstructed image in the encoding direction at period PT which is in proportion to the number of echoes as shown in Fig. 3 (in which symbols IM represent an image which is the subject). Since the artifacts are usually generated in places, the contrast of each of which is low, there is a risk of a misdiagnosis.

A method according to the preamble of claim 1 is known from WO-A-93/01509 or EP-A-0 529 527.

The present invention was made to overcome the foregoing problems experienced with the conventional technology and therefore an object of the same is to prevent generation of ghost-like artifacts peculiar to the conventional fast SE method so as to obtain an image exhibiting excellent image quality.

This object is achieved by a method according to claim 1 and an apparatus according to claim 8, respectively.

Further developments of the invention are given in the dependent claims.

One exciting 90°-RF pulse is supplied to a subject to be inspected, and then a plurality of (for example, four) refocusing pulses (180°- pulses) are supplied. As a result, spin echo signals are generated correspondingly to the respective refocusing pulses. The order of the sizes of the phase-encoding gradient fields to be applied at the time of generating the plurality of the spin echo signals is changed at each radio frequency excitation by the acquisition order changing means. The method of the change is, for example, a method using a table of random numbers to randomly change the order.

When the received spin echo signals are processed, the data arranging means disposes echo data in the Fourier space in accordance with the changed order. As a result, the echo data arranged in the Fourier space is, as it is, two-dimensionally Fourier-transformed so that the image is reconstructed.

Since the order of the sizes of the phase-encoding gradient fields are changed at each radio frequency excitation as described above, even if the subject of the inspection is moved during the scan operation, the periodicity of the amplitude change of echo data appearing in the direction ke in the Fourier space (k space) at the period, which is in proportion to the number of echoes, can be relaxed. Thus, the ghost-like artifacts appearing depending upon the periodicity can substantially be removed,

The accompanying drawings which are incorporated in and consitute a part of this specification, illustrate embodiments of the invention and, together with the description, serve to explain the principles of the invention; in which:
Fig. 1 is a pulse sequence diagram which illustrates an example of the conventional fast SE method;
Fig. 2 is a diagram which illustrates the data acquisition order in the k space by the conventional fast SE method;
Fig. 3 is a diagram which illustrates an image having a ghost-like artifact peculiar to the fast SE method;
Fig. 4 is a block diagram which illustrates the overall body of an example of a magnetic resonance imaging apparatus according to the present invention;
Fig. 5 is a schematic flow chart of an example of a process of an echo data acquiring order performed by a controller;
Fig. 6 is a pulse sequence diagram which illustrates an example of a fast SE method;
Fig. 7 is a table which illustrates an example of the order of the size (the area ratio) of the phase-encoding gradient field that is changed at each radio frequency excitation in a manner that the conventional method and an embodiment of the present invention are subjected to a comparison;
Fig. 8A is a graph of an example of change in error component E (ke) in the k space realized by a usual SE method;
Fig. 8B is a graph of PSF corresponding to the right half portion of Fig. 8A;
Fig. 9A is a graph of an example of change in error component E (ke) in the k space realized by a conventional fast SE method;
Fig. 9B is a graph of PSF corresponding to the right half portion of Fig. 9A;
Fig. 10A is a graph of an example of change in error component E (ke) in the k space realized by a fast SE method according to the present invention;
Fig. 10B is a graph of PSF corresponding to the right half portion of Fig. 10A;
Fig. 11 is table illustrating a variation of the data acquisition order expresed by the order of the levels of the phase-encoding field pulses;
Fig. 12 is a table illustrating another variation of the data acquisition order expressed by the order of the levels of the phase-encoding field pulses; and
Fig. 13 is a schematic flow chart of a variation of a process performed by a controller.

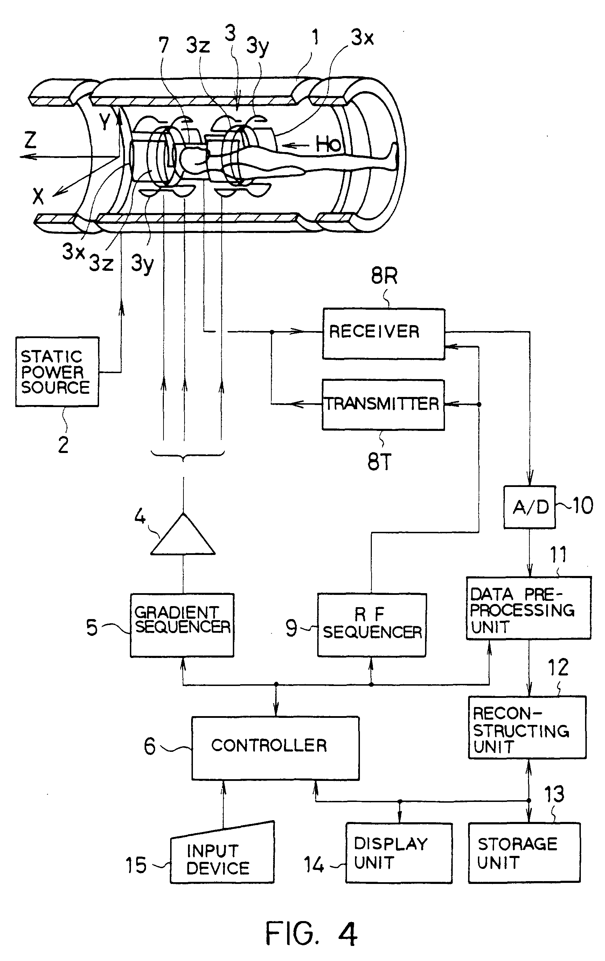

An embodiment of the present invention will now be described with reference to Figs. 4 to 10.

The schematic structure of a magnetic resonance imaging apparatus according to this embodiment will now be described with reference to Fig. 4. The magnetic resonance imaging apparatus according to this embodiment comprises a magnet portion for generating an static field (magnetic field), an gradient field portion for supplying position information to the static field, a transmitting/receiving portion for selective excitation and receiving an MR signal, and a control/calculating portion for controlling the system and reconstructing the image.

The magnet portion comprises a magnet 1 of, for example, a superconductive type and an static power source 2 for supplying an electric current to the magnet 1 so as to generate static field (magnetic field) H₀ in the Z axis direction in a cylindrical field of view into which a subject P to be inspected is inserted.

The gradient field portion comprises three gradient coils 3x to 3z in the X, Yand Z axial directions, the three gradient coils 3x to 3 z being included in the magnet 1. The gradient field portion further comprises an gradient power source 4 for supplying electric currents to the gradient coils 3x to 3z, and an gradient sequencer 5 for controlling the power source 4. The gradient sequencer 5 comprises a computer to receive, from a controller 6 (having a computer mounted thereon) for totally controlling the apparatus, a signal for instructing an acquiring sequence relating to the fast SE method. As a result, the gradient sequencer 5, in accordance with the instructed sequence, controls the supply of gradient fields (magnetic fields) in the X, Yand Z axial directions and the intensity of each of the gradient fields so that the gradient fields can be superposed on the static field H₀. In this embodiment, the gradient field in the Z-axial direction among the three axes perpendicular to one another is made to be slicing gradient field G_{S}, that in the X-axial direction is made to be reading gradient field G_{R} and that in the Y-axial direction is made to be phase-encoding gradient field G_{E}.

The transmitting/receiving portion comprises a RF coil 7 disposed in the field of view in the magnet 1 at a position near the subject P to be inspected, a transmitter 8T and a receiver 8R connected to the RF coil 7, and an RF sequencer 9 (having a computer mounted thereon) for controlling the operation timing of each of the transmitter 8T and the receiver 8R. The transmitter 8T and the receiver 8R are, under control of the RF sequencer 9, supply RF electric current pulses having a Larmor frequency for exciting nuclear magnetic resonance (NMR) to the RF coil 7 and as well as subject an MR signal (a radio frequency signal) received by the RF coil 7 to a variety of processes so that an echo signal is formed.

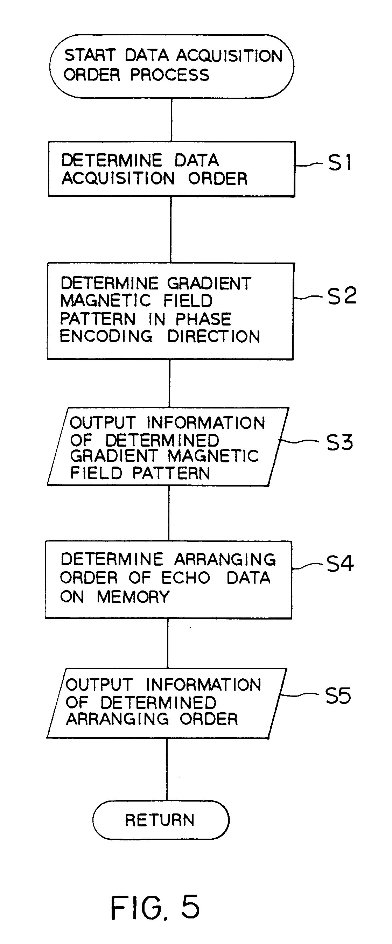

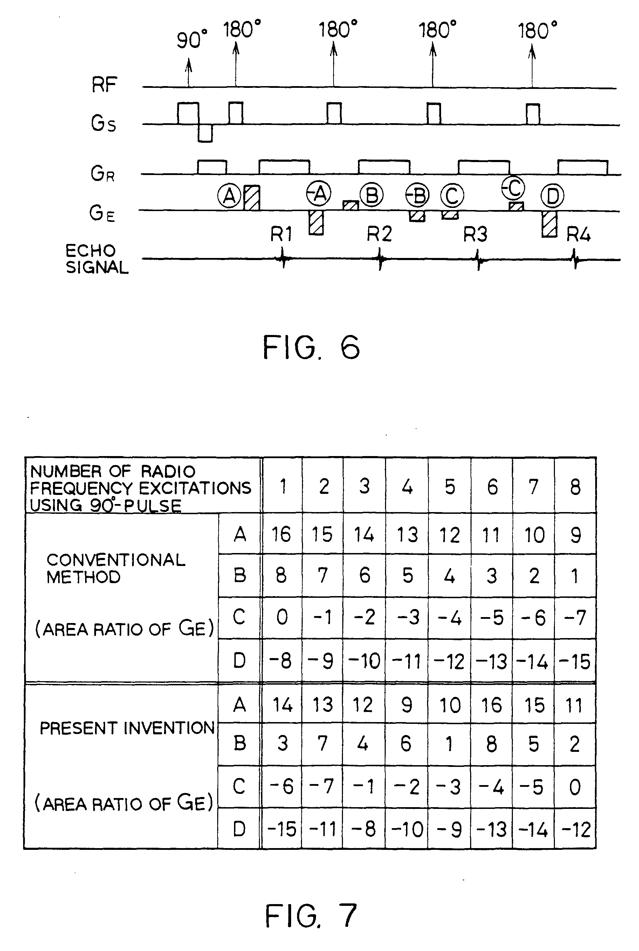

The control/calculating portion comprises the foregoing controller 6, an A/D converter 10 for converting the echo signal formed by the receiver 8R into a digital quantity, and a data pre-processing unit 11 that receives the A/D converted signal to dispose data in the k space. Furthermore, a reconstructing unit 12 for reconstructing the image by a two-dimensional Fourier transformation method, a storage unit 13 for storing reconstructed image data, a display unit 14 for displaying the image, and an input device 15 are disposed on the output side of the data pre-processing unit 11. The controller 6 includes the computer as described above so as to control the contents and timing of the operations of the gradient sequencer 5 and the RF sequencer 9 in accordance with the pulse sequence of the fast SE method (see Fig. 6) while synchronizing the gradient sequencer 5 and the RF sequencer 9 with each other. The foregoing control includes control of the data acquisition order to be described later with reference to Fig. 5.

The operation of this embodiment will now be described.

When the magnetic resonance imaging apparatus is activated, the controller 6 performs a program shown in Fig. 5 in addition to a predetermined main program relating to the fast SE method. That is, whenever the radio frequency excitation operation using one 9 0°- pulse is performed, a random data acquisition order is determined in the k space (step S1 shown in Fig. 5). Furthermore, a gradient field pattern in the phase encoding direction is determined in accordance with the thus-determined order (step S2 shown in Fig. 5).

The pattern is determined as shown in Figs. 6 and 7 in such a manner that the order of levels of the phase-encoding gradient field pulse G_{E} to be applied to each echo signal is changed whenever the radio frequency excitation operation using one 90°- pulse is performed. When the determination is made, a reference is made to a table of random numbers stored previously. Fig. 7 shows the levels (area ratio: expressed by relative values) of phase-encoding gradient field pulses G_{E} = A to D with respect to four echoes (refer to Fig. 6) which are randomly changed in accordance with the times (one to eight times) of the radio frequency excitation operations each using one 90°- pulse in such a manner that the level realized by a conventional method and the method according to the present invention are shown.

In Fig. 7, acquisition orders corresponds to orders in levels of the area ratios of G_{E}; the four laterally-aligned orders of figures shown thereon corresponds to the acquisition orders in each divided regions of the k space. In detail, the phase encoding field pulses G_{E} =16 to 9 mean the uppermost to lowermost positions in the uppermost divided region R1 of the k space (see Fig. 2), G_{E} = 8 to 1 mean the uppermost to lowermost positions in the 2nd-uppermost divided region R2, G_{E} = 0 to -7 mean the uppermost to lowermost positions in the lower divided region R3, and G_{E} = -8 to -15 mean the uppermost to lowermost positions in the lowest divided regions R4.

As can be understood from Fig. 7, the levels of the gradient field pulses G_{E} = A to D are changed in the same order whenever the radio frequency excitation is performed with the conventional method. As contrasted with this, although the values of the area ratio are, in this embodiment, limited due to the necessity of acquiring echo data that can be arranged in the overall k space, the order of levels of the gradient field pulses G_{E} = A to D is changed randomly in the foregoing range whenever the radio frequency excitation operation is performed.

Then, information (magnetic field pattern information) of the phase-encoding gradient field pulses G_{E} = A to D determined in such a manner that the order of levels is changed randomly is outputted to the gradient sequencer 5 (step S3 shown in Fig. 5). As a result, also the pulse signal for controlling the gradient field instructed to the gradient power source 4 by the gradient sequencer 5 is, as shown in Fig. 6, formed into a shape that the order of levels of the gradient field pulses G_{E} = A to D is changed randomly at each radio frequency excitation, the shape being in the form according to the fast SE method.

In step S4 a reference is made to information about the data acquisition order determined previously in step S1 so as to determine the arranging order of echo data on the memory (step S4 shown in Fig. 5). That is, since the data aquisition order is, in this embodiment, changed randomly at each radio frequency excitation in the direction ke in the k space, data arrangement in the k space does not correspond to the original image if data is written on the memory in the acquisition order of the echo signals. Therefore, the memory address in the k space corresponding to the original image is obtained in accordance with information of the changed data acquisition order. The memory address can be obtained by, for example, a method in which the address corresponding to ke obtainable from the time integration value of the encoding-directional gradient field pulses immediately before the acquisition of certain echo data is made to be the address of a portion in which the echo data is stored.

Information of the thus-determined arranging order is outputted from the controller 6 to the data pre-processing unit 11 (step S5 shown in Fig. 5).

In this embodiment, steps S1 to S3 shown in Fig. 5 and the gradient sequencer 5 among the foregoing structure and the processes constitute the acquisition order changing means according to the present invention, while steps S4 and S5 shown in Fig. 5 and the data pre-processing unit 11 constitute the data arranging means according to the present invention.

The gradient sequencer 5, which has received pattern information of phase-encoding gradient field G_{E} from the controller 6, controls the slicing gradient field G_{S}, the reading gradient field G_{R} and the phase-encoding gradient field G_{E} in accordance with the sequence shown in Figs. 6 and 7. Simultaneously, the RF sequencer 9, which has received the instruction of the fast SE method from the controller 6, supplies a 90°- pulse and 180°- pulses to the subject P to be inspected in accordance with the sequence shown in Fig. 6.

That is, the slicing gradient field G_{S} is initially supplied from the gradient power source 4 through the gradient coils 3z and 3z. When the gradient field G_{S} has been first-transited to a predetermined value, the 90°- pulse is, only one time, supplied through the transmitter 8T and the RF coil 7. As a result, a region of a predetermined slice width of the subject is selectively excited and as well as the excited atomic nucleus spin in the sliced plane is flipped to the y'-axis (the rotational coordinates).

Then, simultaneously with the inversion of the slicing gradient field G_{S}, the reading gradient field G_{R} is supplied through the gradient coils 3x and 3x. The foregoing supply is performed so as to align, at the central time of each echo, the phases of the atomic nucleus spins arranged in the G_{R} direction in the selectively sliced plane.

Then, a first 180°- pulse is supplied together with the slicing gradient field G_{S}. As a result, the nucleus spins are rotated around the y'-axis by an angular degree of 180°. Furthermore, the first phase-encoding gradient field G_{E} = A is supplied to the subject P to be inspected from the gradient power source 4 through the gradient coils 3y and 3y. Then, with the reading field G_{R} to be supplied through the gradient coils 3x and 3x, the first spin echo signal R1 is collected through the RF coil 7.

Then, inverted phase-encoding gradient field
G_{E} = - A is supplied for the purpose of restoring state ke = 0 when the 180°- pulse is supplied in order to prevent deterioration in the image quality due to a stimulated echo.

Then, a second 180°- pulse is supplied together with the slicing gradient field G_{S}, and then the second phase-encoding gradient field G_{E} = B is supplied. Thus, the second spin echo signal R2 is, simultaneously with the supply of the reading gradient field G_{R}, collected through the RF coil 7.

Similarly, the third and fourth spin echo signals R3 and R4 are collected.

The collection of the four echoes R1 to R4 is repeated at each radio frequency excitation using one 90°-pulse and to be performed by a predetermined number of times.

The thus-collected echo signals are sequentially supplied to the receiver 8R in which the echo signals are subjected to amplification, intermediate frequency inversion, phase detection and low frequency amplification processes. Then, the echo signals are converted into digital quantity echo data by the A/D converter 1 0. The echo data is supplied to the data pre-processing unit 11. As described above, the data pre-processing unit 11 has received the arranging order information of the echo data on the memory from the controller 6 to write the echo data at the address positions according to the arranging order. As a result, data is, simultaneously with the writing operation, arranged in a memory region that can be Fourier-transformed and corresponds to the k space.

Note that the operation of writing echo data items onto the memory region (k space) may be performed in such a manner that all supplied echo data items are once stored in the memory in the order of the supply and then the echo data items are rearranged in accordance with the foregoing arranging order.

Image data thus enclosed in the memory region is supplied to the reconstructing unit 12 so as to be reconstructed to an image by two-dimensional Fourier transformation. The image is stored in the storage unit 13 and as well as displayed on the display unit 14.

Since the improved fast SE method is employed in which the order of levels of the phase-encoding gradient field pulses is changed randomly at each high frequency excitation operation, error components of echo data in the direction ke in the k space are considerably changed even if the echo signal is changed at each radio frequency excitation due to, for example, the movement of the body of the subject P to be inspected. Therefore, the error components are dispersed or set off in the direction ke to be decreased. Thus, the periodicity of the modulation of the amplitude of echo data that appears in the direction ke at a period, which is in proportion to the number of echoes, can significantly be relaxed.

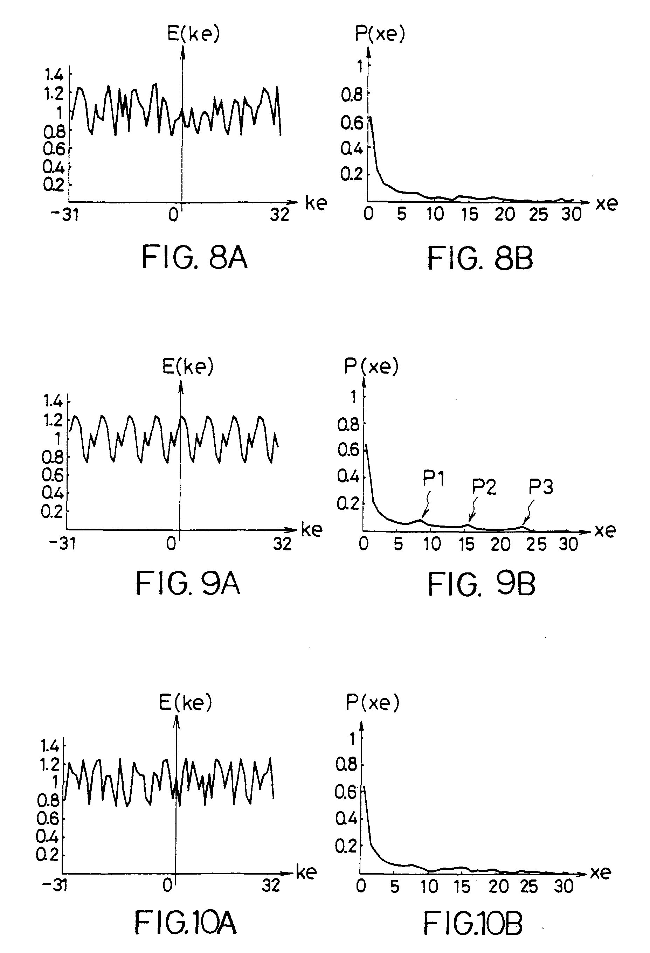

The state in which the periodicity is relaxed will now be described with reference to Figs. 8 to 10 while being contrasted with the conventional method. Fig. 8 illustrates a usual SE method (as a reference), Fig. 9 illustrates the conventional fast SE method (8 echoes) and Fig. 10 illustrates the fast SE method (8 echoes) according to the present invention. Among the foregoing figures, (A) illustrates change in the error component E(ke) of the amplitude of echo data in the direction ke in the k space(the axis of abscissa stands for the position of the spatial frequency in the direction ke), (B) illustrates results of simulation of a PSF (a Point Spread Function) that can be obtained by Fourier transforming curve E(ke) in the right half portion of (A). It should be noted that E(ke) stands for relative values such that E(ke) = 1 shows "no error". The PSF of the curve E (ke) is formed into a horizontally symmetrical shape.

As can be understood from the foregoing figures, the usual SE method involves relatively irregular change of the amplitude of data in the k space (refer to Fig. 8A) and thus ghost-like artifacts are dispersed, causing the ghost-like artifacts to be relatively non-conspicuous (refer to Fig. 8B). However, a long time takes to complete the scan operation as compared with the fast SE method.

The conventional fast SE method encounters irregular change in the amplitude in each divided region assigned to each echo in the k space as shown in Fig. 9A. However, the changing pattern is the same in each divided region. Therefore, a considerably conspicuous periodicity as shown in Fig. 9B appears in the PSF (refer to peaks P 1 to P3 shown in Fig. 9B), the periodicity causing the foregoing ghost-like artifacts to appear (refer to Fig. 3).

On the other hand, the fast SE method according to the present invention involves different changing patterns of the amplitude in each divided region of the k space. Therefore, the periodicity of the amplitude change as is experienced with the conventional fast SE method can be prevented, as can be understood from Fig. 10A. As a result, the peaks of the PSF curve corresponding to it is considerably weakened (see Fig. 10B. Thus, the ghost-like artifacts, which have been experienced with the conventional method and which appear at the periods which are in proportion to the number of echoes peculiar to the fast SE method can significantly be decreased.

As a result, the resolution of the reconstructed image can be improved. Since the image quality can be improved simultaneously, the capability of drawing fine structures can be improved and thus the fear of the misdiagnosis occurring due to the ghost-like artifact can significantly be prevented.

The fast SE method according to the present invention is not limited to the foregoing case where the number of echoes is four or eight. The method can be adapted regardless of the number of echoes.

As described above, the magnetic resonance imaging apparatus according to the present invention has the arrangement that the order of levels of the phase-encoding, to which a plurality of spin echo signals are subjected, is changed at each radio frequency excitation and echo data is arranged in the Fourier space to correspond to the changed acquisition order. Therefore, even if the subject of the inspection is moved during the scan operation, the periodicity of the amplitude change of echo data appearing in the direction ke in the Fourier space (k space) at the period, which is in proportion to the number of echoes, can be relaxed. Thus, the ghost-like artifacts appearing depending upon the periodicity can substantially be removed from the reconstructed image. Consequently, an image exhibiting excellent image quality and resolution as compared with those obtainable from the conventional fast SE method can be formed by a scan operation at a high speed.

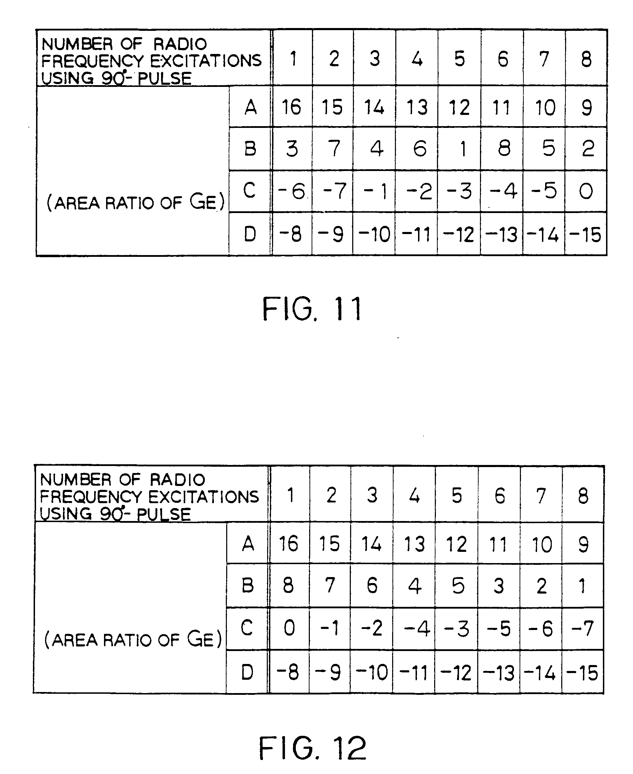

Variations of the foregoing embodiment will then be described with reference to Figs. 11 to 13.

Fig. 11, which corresponds to Fig. 7, shows another pattern of the data acquisition order for the fast SE method (4 echoes). As can be understood from the figure, the acquisition orders of only the second and the third spin echo signals are randomly changed in the same way as in Fig. 7, while those of the first and fourth spin echo signals are regularly changed one by one in one direction ke of the k space. Thus it is still possible to relax the periodicity of the amplitude change of echo data appearing in the direction ke in the Fourier space.

Fig. 12 shows still another pattern of the data acquisition order for the fast SE method (4 echoes). This pattern exemplifies the least limited changing degree in the data acquisition order; only for the second and third spin echo signals, the acquisition orders are alternately changed in two times of radio freuency excitations (see excitation numbers 4 and 5). This acquisition orders are very limited in their changing degrees, but still effective in localy removing artifacts in the same manner described above.

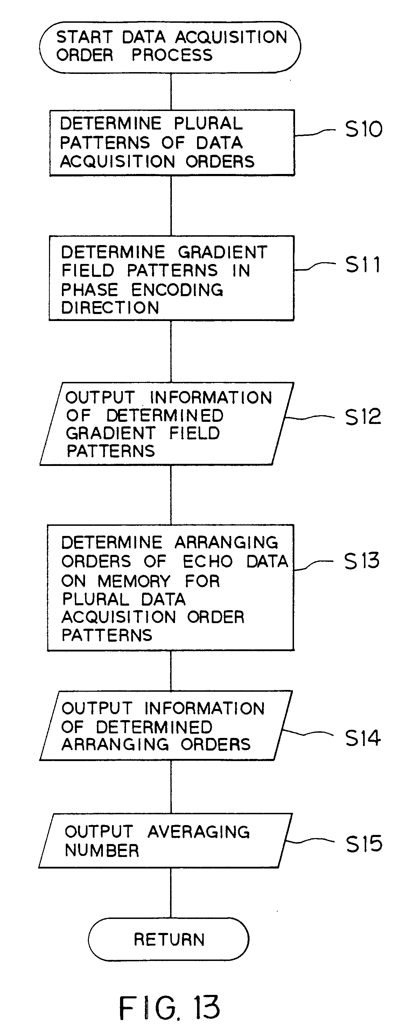

Furthermore, Fig. 13 shows a schematic flow chart of a processing according to another variation, carried out by the controller 6 in Fig. 4. This processing concerns a fast SE method in which one frame image is made from a plurality of frame image data with averaging technique of pixel-by-pixel calculation.

In order to this sequence, the controller 6 determines a plurality of patterns of data acquisition orders (step s10 shown in Fig. 13). This determination is made, for instance, by selection of desired pattern P₁ to Pₙ from previously stored pattern data. A plurality of acquisition order patterns P₁ to Pₙ (for example, n=3) thus-determined as in Fig. 7 are each for a plurality of data acquisitions, but different in random order from each other.

Further, a plurality of gradient field patterns in the phase encoding direction is determined in accordance with the plurality of acquisition order patterns (step s11 shown in Fig. 13). Then, information about the determined phase encoding gradient patterns are output to the gradient sequencer 5 to control phase encoding gradient pulses G_{E} for each acquisition of plural frame data forming one frame image (step s12 shown in Fig. 13).

Further, a plurality of arranging orders of echo data on a memory are determined each correspondingly to the plural acquisition order patterns P₁ to Pₙ decided in step s10(step s13 in Fig. 13). Information of those determined arranging orders are output to the data pre-processing unit 11 in Fig. 4 (step s14 in Fig. 13). In addition, the value of averaging number n is output to the pre-processing unit 11 (step s15 in Fig. 13).

Accordingly, based on different random patterns P₁ to Pₙ of acquisition orders, a plurality of frame echo data are each acquired to be averaged pixel by pixel, averaged one frame data becoming one frame image. Therefore, the averaging effect is remarkably enhanced by adopting different random patterns P₁ to Pₙ of acquisition orders, resulting in images of higher quality, with no ghost-like artifacts discussed above.

On one hand, it is possible to apply another variation of the pulse sequence to the present invention. For example, a sequence of combined gradient echoes and spin echoes (referred to as a GRASE method) can be used.

Although the invention has been described in its preferred form with a certain degree of particularty, this is not meant to be limiting and the preferred form can be changed in the details of construction and the combination and arrangement of parts may be resorted to without departing from the scope of the invention as defined by the appending claims.

## Claims

1. A method of magnetic resonance imaging in which a set of echo data (R1-R4) arranged in a Fourier space for reconstructing an image frame is acquired by a series of processes including a pulse sequence repeating, at each of a plurality of radio frequency excitations, an application of one exciting pulse to a subject (P) placed in a static magnetic field (Ho) to magnetically excite a desired sliced plane of the subject, a sequential application of a plurality of refocusing pulses to the sliced plane to sequentially generate a plurality of spin echo signals (R1-R4), and an application of a plurality of phase encoding gradient pulses (A-D) of different levels to the plurality of spin echo signals, the Fourier space being divided into a plurality of regions in a predetermined direction of the spatial frequency of phase encoding (ke) of the Fourier space, said plurality of regions being equal in number to the plurality of spin echo signals corresponding to the refocusing pulses, the method of magnetic resonance imaging comprising the steps of
changing the levels of the phase encoding gradient pulses (A-D) according to a predetermined acquisition order at each of the plurality of radio frequency excitations, said acquisition order being determined so as to cover all points in said predetermined direction (ke) of the Fourier space;
receiving the spin echo signals to which the phase encoding gradient pulses of the changed levels in accordance with the acquisition order are applied; and
arranging the echo data processed from the echo signals in the Fourier space corresponding to the acquisition order,
characterized in that said acquisition order is determined to be independently changed among the plurality of regions.

2. The method of magnetic resonance imaging according to claim 1, wherein said acquisition order is determined to be independently and randomly changed among the plurality of regions.

3. The method of magnetic resonance imaging according to claim 1 or 2, wherein said acquisition order is determined to produce unequal acquisition distances in said predetermined direction (ke) at at least two of the plurality of radio frequency excitations.

4. The method of magnetic resonance imaging according to one of claims 1 to 3, wherein said acquisition order is determined based on a table of random numbers.

5. The method of magnetic resonance imaging according to one of claims 1 to 4, wherein said acquisition order is determined so that the levels of two or more of the phase encoding gradient pulses (A-D) are independently and randomly changed in time elapsing when each of the phase encoding gradient pulses (A-D) is repeatedly applied.

6. The method of magnetic resonance imaging according to one of claims 1 to 5, wherein said pulse sequence is a sequence based on a fast spin echo method.

7. The method of magnetic resonance imaging according to one of claims 1 to 6, in which a plurality of said sets of echo data (R1-R4) each arranged in the Fourier space for reconstructing an image frame are acquired, and said plurality of sets of echo data is averaged pixel by pixel.

8. An apparatus for magnetic resonance imaging adapted for carrying out a method of magnetic resonance imaging as defined in one of claims 1 to 7, comprising:
changing means (5, 6) for performing the step of changing the levels of the phase encoding gradient pulses (A-D) according to said predetermined acquisition order at each of the plurality of radio frequency excitations, said acquisition order being determined so as to cover all points in said predetermined direction (ke) of the Fourier space and being determined to be independently changed among the plurality of regions;
receiving means (8R, 10) for performing the step of receiving the spin echo signals to which the phase encoding gradient pulses of the changed levels in accordance with the acquisition order are applied; and
arranging means (6, 11) for performing the step of arranging the echo data processed from the echo signals in the Fourier space correspondingly to the acquisition order.

## Patentansprüche

1. Verfahren zur Magnetresonanzbildgebung, bei dem ein Satz von Echodaten (R1-R4), die in einem Fourier-Raum angeordnet sind, zur Rekonstruktion eines Bildrahmens erfaßt wird, durch eine Abfolge von Prozessen, die eine Pulssequenzwiederholung, bei jeder von Hochfrequenzanregungen, ein Anlegen eines Anregungspulses an ein Subjekt (P), das in einem statischen Magnetfeld (Ho) plaziert ist, um eine gewünschte Schnittfläche des Subjektes magnetisch anzuregen, ein aufeinanderfolgendes Anlegen einer Mehrzahl von Refokussierungspulsen an die Schnittebene zum aufeinanderfolgenden Erzeugen einer Mehrzahl von Spin-Echo-Signalen (R1-R4) und ein Anlegen einer Mehrzahl von Phasencodierungsgradientenpulsen (A-D) von unterschiedlichen Pegeln an die Mehrzahl von Spin-Echo-Signalen enthält, wobei der Fourier-Raum in eine Mehrzahl von Bereichen in einer vorbestimmten Richtung der Ortsfrequenz der Phasencodierung (ke) des Fourier-Raums unterteilt ist, wobei die Mehrzahl von Bereichen in der Anzahl gleich der Mehrzahl der Spin-Echo-Signale, die den Refokussierungspulsen entsprechen, ist, wobei das Verfahren der Magnetresonanzbildgebung die Schritte
des Änderns der Niveaus der Phasencodierungsgradientenpulse (A-D) entsprechend einer vorbestimmten Erfassungsreihenfolge bei jeder aus der Mehrzahl der Hochfrequenzanregungen, wobei die Erfassungsreihenfolge so bestimmt ist, daß alle Punkte in der vorbestimmten Richtung (ke) des Fourier-Raums abgedeckt sind,
des Empfangens der Spin-Echo-Signale, auf die die Phasencodierungsgradientenpulse der geänderten Niveaus entsprechend der Erfassungsreihenfolge angewandt werden, und
des Anordnens der Echodaten, die aus den Echosignalen in dem Fourier-Raum verarbeitet worden sind, entsprechend der Erfassungsreihenfolge,
aufweist, dadurch gekennzeichnet,
daß die Erfassungsreihenfolge so bestimmt ist, daß sie sich unter der Mehrzahl von Bereichen unabhängig ändert.

2. Verfahren zur Magnetresonanzbildgebung nach Anspruch 1, bei dem
die Erfassungsreihenfolge so bestimmt ist, daß sie unter der Mehrzahl von Bereichen unabhängig und willkürlich geändert ist.

3. Verfahren zur Magnetresonanzbildgebung nach Anspruch 1 oder 2, bei dem
die Erfassungsreihenfolge so bestimmt ist, daß ungleiche Erfassungsabstände in der vorbestimmten Richtung (ke) bei mindestens zwei aus der Mehrzahl der Hochfrequenzanregungen erzeugt werden.

4. Verfahren zur Magnetresonanzbildgebung nach einem der Ansprüche 1 bis 3, bei dem
die Erfassungsreihenfolge so bestimmt ist, daß sie auf einer Tabelle von Zufallszahlen basiert.

5. Verfahren zur Magnetresonanzbildgebung nach einem der Ansprüche 1 bis 4, bei dem
die Erfassungsreihenfolge so bestimmt ist, daß die Niveaus der zwei oder mehr der Phasencodierungsgradientenpulse (A-D) unabhängig und willkürlich in der Zeit, die abläuft, wenn jeder der Phasencodierungsgradientenpulse (A-D) wiederholt angelegt wird, geändert werden.

6. Verfahren zur Magnetresonanzbildgebung nach einem der Ansprüche 1 bis 5, bei dem
die Pulsfolge eine Folge ist, die auf einem schnellen Spin-Echo-Verfahren basiert.

7. Verfahren zur Magnetresonanzbildgebung nach einem der Ansprüche 1 bis 6, bei dem
eine Mehrzahl der Sätze von Echodaten (R1-R4), die jeweils in dem Fourier-Raum zum Rekonstruieren eines Bildrahmens angeordnet sind, erfaßt werden, und die Mehrzahl der Sätze von Echodaten Pixel für Pixel gemittelt wird.

8. Vorrichtung zur Magnetresonanzbildgebung, die angepaßt ist zum Ausführen eines Verfahrens zur Magnetresonanzbildgebung, wie es in einem der Ansprüche 1 bis 7 definiert ist, die aufweist:
ein Änderungsmittel (5, 6) zum Ausführen des Schrittes der Änderung der Niveaus der Phasencodierungsgradientenpulse (A-D) entsprechend der vorbestimmten Erfassungsreihenfolge bei jeder aus der Mehrzahl der Hochfrequenzanregungen, wobei die Erfassungsreihenfolge so bestimmt wird, daß sie alle Punkte in der vorbestimmten Richtung (ke) des Fourier-Raums abdeckt und sie so bestimmt wird, daß sie unter der Mehrzahl von Bereichen unabhängig geändert wird;
ein Empfangsmittel (8R, 10) zum Ausführen des Schrittes des Empfangens der Spin-Echo-Signale, auf die die Phasencodierungsgradientenpulse der geänderten Niveaus entsprechend der Erfassungsreihenfolge angewandt werden; und
ein Anordnungsmittel (6, 11) zum Ausführen des Schrittes des Anordnens der Echodaten, die aus den Echosignalen in dem Fourier-Raum verarbeitet worden sind, entsprechend der Erfassungsreihenfolge.

## Revendications

1. Procédé d'imagerie par résonance magnétique, dans lequel un groupe de données d'écho (R1-R4) agencé dans un espace de Fourier pour reconstituer une trame d'image est acquis par une série de processus qui inclut la répétition d'une séquence d'impulsions, lors de chacune parmi une pluralité d'excitations de fréquences radio, l'application d'une impulsion d'excitation à un sujet (P) placé dans un champ magnétique statique (Ho) afin d'exciter de façon magnétique un plan de coupe désiré du sujet, l'application séquentielle d'une pluralité d'impulsions de refocalisation au plan de coupe pour engendrer en séquence une pluralité de signaux d'écho de spin (R1-R4), et l'application d'une pluralité d'impulsions de gradient de codage de phase (A-D) à différents niveaux à la pluralité de signaux d'écho de spin, l'espace de Fourier étant divisé en une pluralité de régions dans une direction prédéterminée de la fréquence spatiale du codage de phase (ke) de l'espace de Fourier, et ladite pluralité de régions étant en nombre égal au nombre de la pluralité de signaux d'écho de spin qui correspondent aux impulsions de refocalisation, le procédé d'imagerie par résonance magnétique comprenant les opérations consistant à:
- changer les niveaux des impulsions de gradient de codage de phase (A-D) en accord avec un ordre d'acquisition prédéterminé à chacune de parmi la pluralité d'excitations de fréquences radio, ledit ordre d'acquisition étant déterminé de manière à couvrir tous les points dans ladite direction prédéterminée (ke) de l'espace de Fourier;
- recevoir les signaux d'écho de spin auquel sont appliqués les impulsions de gradient de codage de phase avec les niveaux changés en accord avec l'ordre d'acquisition ; et
- arranger les données d'écho traitées à partir des signaux d'écho dans l'espace de Fourier en correspondance de l'ordre d'acquisition,
caractérisé en ce que ledit ordre d'acquisition est déterminé de façon à être changé indépendamment parmi la pluralité de régions.

2. Procédé d'imagerie par résonance magnétique selon la revendication 1, dans lequel ledit ordre d'acquisition est déterminé de manière à être changé indépendamment et aléatoirement parmi la pluralité de régions.

3. Procédé d'imagerie par résonance magnétique selon l'une ou l'autre des revendications 1 et 2, dans lequel ledit ordre d'acquisition est déterminé de manière à produire des distances d'acquisition inégales dans ladite direction prédéterminée (ke) à au moins deux parmi la pluralité d'excitations de fréquences radio.

4. Procédé d'imagerie par résonance magnétique selon l'une des revendications 1 à 3, dans lequel ledit ordre d'acquisition est déterminé en se basant sur une table de nombres aléatoires.

5. Procédé d'imagerie par résonance magnétique selon l'une des revendications 1 à 4, dans lequel ledit ordre d'acquisition est déterminé de telle façon que les niveaux de deux ou plusieurs des impulsions de gradient de codage de phase (A-D) sont changés indépendamment et aléatoirement quant à l'écoulement du temps lorsque chacune des impulsions de gradient de codage de phase (A-D) est appliquée de façon répétée.

6. Procédé d'imagerie par résonance magnétique selon l'une des revendications 1 à 5, dans lequel ladite séquence d'impulsions est une séquence basée sur un procédé d'écho de spin rapide.

7. Procédé d'imagerie par résonance magnétique selon l'une des revendications 1 à 6, dans lequel une pluralité desdits groupes de données d'écho (R1-R4) arrangés chacun dans l'espace de Fourier sont acquis pour reconstituer une trame d'image, et ladite pluralité de groupes de données d'écho est moyennée pixel par pixel.

8. Appareil d'imagerie par résonance magnétique adapté pour la mise en oeuvre d'un procédé d'imagerie par résonance magnétique selon l'une des revendications 1 à 7, comprenant :
- des moyens de changement (5, 6) pour exécuter l'opération consistant à changer les niveaux des impulsions de gradient de codage de phase (A-D) en accord avec ledit ordre d'acquisition prédéterminé à chacune parmi la pluralité d'excitations de fréquences radio, ledit ordre d'acquisition étant déterminé de manière à couvrir tous les points dans ladite direction prédéterminée (ke) de l'espace de Fourier et étant déterminé de manière à être indépendamment changé parmi la pluralité de régions ;
- des moyens de réception (8R, 10) pour exécuter l'opération consistant à recevoir les signaux d'écho de spin auquel sont appliquées les impulsions de gradient de codage de phase avec les niveaux changés en accord avec l'ordre d'acquisition ; et
- des moyens d'arrangement (6, 11) pour exécuter l'opération consistant à arranger les données d'écho traitées depuis les signaux d'écho dans l'espace de Fourier en correspondance de l'ordre d'acquisition.
